# EUROPÄISCHE PATENTSCHRIFT

(11) **EP 2 890 263 B1**
(45) Veröffentlichungstag und Bekanntmachung des Hinweises auf die Patenterteilung: **28.09.2016**
(21) Anmeldenummer: 12753129.1
(22) Anmeldetag: 30.08.2012
(51) Int. Cl.: A43D 1/02, A41H 3/00, G06Q 30/00

(54) **VERFAHREN UND VORRICHTUNG ZUR KATEGORISIERUNG VON KLEIDUNGSSTÜCKEN SOWIE VERFAHREN UND VORRICHTUNG ZUR AUSWAHL VON SCHUHWERK MIT VERBESSERTER PASSFORM**
METHOD AND APPARATUS FOR CATEGORIZING ITEMS OF CLOTHING AND METHOD AND APPARATUS FOR SELECTING FOOTWEAR HAVING AN IMPROVED FIT
PROCÉDÉ ET DISPOSITIF DE CATÉGORISATION DE VÊTEMENTS, ET PROCÉDÉ ET DISPOSITIF DE SÉLECTION DE CHAUSSURES À CHAUSSANT AMÉLIORÉ

(43) Veröffentlichungstag der Anmeldung: 08.07.2015
(73) Patentinhaber: Corpus.E AG, 70178 Stuttgart (DE)
(72) Erfinder: RUTSCHMANN, Dirk, 70180 Stuttgart (DE)
(74) Vertreter: Prinz & Partner mbB
(86) Internationale Anmeldenummer: PCT/EP2012/066918
(87) Internationale Veröffentlichungsnummer: WO 2014/032723

(56) Entgegenhaltungen:
- EP-A1- 2 119 377
- WO-A1-2007/144582
- WO-A2-00/49480
- WO-A2-2006/013558

## Beschreibung

Die Erfindung betrifft ein Verfahren sowie eine Vorrichtung zur Kategorisierung von Kleidungsstücken. Außerdem betrifft die Erfindung ein Verfahren und eine Vorrichtung zur Auswahl von Schuhwerk mit verbesserter Passform.

### Technischer Hintergrund

Für die Auswahl eines passenden Schuhs wird meistens die Standardisierungsinformation der "Schuhgröße" als Ausgangsbasis genommen, um bei einem Schuhmodell die richtige Größenvariante zu finden. Die "Schuhgröße" soll dabei eine komplexe dreidimensionale Schuhinnenform beschreiben und vergleichbar machen. Da verschiedene Schuhe mit gleicher Schuhgrößenangabe jedoch häufig sehr unterschiedlich geformte und auch unterschiedlich lange Schuhinnenformen repräsentieren, kann der Kunde diese Information nur als sehr grobe Näherung heranziehen. Es bleibt ihm in der Regel nichts anderes übrig, als die Passform eines Schuhs durch Anprobieren mittels Versuch-und-Irrtum als passend oder nicht passend zu klassifizieren.

Während dieses physische Anprobieren im stationären Handel möglich und geläufig ist und lediglich den Auswahlprozess erschwert und verlängert, ist dies im Versandhandel, insbesondere bei dem Internet-basierten Schuhkauf, aufgrund der räumlichen Trennung von Ware und Kunde prinzipiell nicht mehr möglich. Dies führt dazu, dass der Internet-Käufer oft mehrere Schuhgrößen/Schuhweiten gleichzeitig bestellt und die nicht passenden Schuhe auf Kosten des Versandhandels wieder retourniert. Hierdurch entstehen dem Versandhandel ganz erhebliche Kosten durch die erforderliche Logistik, die benötigte Sicht-Kontrolle und Neu-Verpackung der Retouren und die erneute Einlagerung. Diese hohen Kosten stellen eine erhebliche Belastung dieses ansonsten modernen und dem Zeitgeist entsprechenden Geschäftsmodells dar.

Die weltweit gebräuchlichen Standardisierungsmethoden für Schuhe, wie die EU-, US- oder UK-Schuhgröße, beispielsweise der sogenannte Pariser Stich in Frankreich oder die Maßeinheit Barleycorn im angelsächsischen Bereich, sind zur Bestimmung der Leisten- und der Schuhinnenlänge entwickelt worden, um verschiedene Schuhformen zu beschreiben und miteinander vergleichbar zu machen. Weitere Schuhgrößensysteme sind meist von den genannten Systemen abgeleitet. Da es sich um stetige Systeme handelt, können sie über Umrechnungstabellen ineinander überführt werden.

Bei diesen klassischen Standardisierungsmethoden wird die komplexe dreidimensionale Form des Schuhinnenraumes mittels eines eindimensionalen Längenmaßes beschrieben. Hierfür werden bei praktisch allen Schuhgrößensystemen insbesondere drei Bezugsgrößen verwendet:
- die Länge des Schuhleistens, der eine Produktionsform ist und den Schuhinnenraum während der Herstellung ausfüllt, wird gemessen,
- die Länge des Schuhinnenraumes wird gemessen,
- mit sogenannten Testläufern, deren Fußlänge vermessen wird, werden empirisch Rückschlüsse auf die zu standardisierenden Schuhe gezogen. Abhängig davon, welche Schuhe den Testläufern mit bekannter Fußlänge passen, werden diese Fußlängen als Schuhgrößen verwendet.

Diese Standardisierungsverfahren mit ihren historisch und regional unterschiedlichen Ursprüngen unterscheiden sich durch die verwendete Maßeinheit und den Nullpunkt zur Längenbestimmung.

Die traditionellen Schuhgrößensysteme zeichnen sich dadurch aus, dass
- Längeneinheiten und adäquate Intervalle, bei einer EU-Schuhgröße beträgt dieses beispielsweise 6,66 mm, festgelegt sind,
- diese Längeneinheiten ineinander transformierbar sind,
- die Systeme weite Verbreitung gefunden haben und
- großes Erfahrungswissen im Umgang mit diesen Systemen vorhanden ist.

Diese Schuhgrößensysteme als Standardisierungsverfahren haben jedoch den Nachteil, dass sie nicht genormt und nicht eindeutig beschrieben sind, insbesondere:
- in Bezug auf das zu vermessende Objekt (Leisten, Schuhinnenraum oder Füße),
- die Messpunkte des Längenmaßes nicht eindeutig definiert sind,
- sie die sogenannten funktionalen oder modischen Zugaben nicht explizit berücksichtigen, die dem Zehenbereich für die Erleichterung der dynamischen Bewegung bzw. aus modischen Gründen längenverändernd hinzugefügt werden,
- verschiedene Maßeinheiten unter gleicher Bezeichnung im Markt vorherrschen, wie beispielsweise beim US-Schuhgrößensystem, bei dem insbesondere die großen Sportschuhhersteller oftmals.anstelle eines halben Barleycorns (ca. 8,466 mm) als Größenstufung 10 mm verwenden,
- die relativ komplexe dreidimensionale Innenform des Schuhs mittels einer starken Vereinfachung auf sehr wenige Maße, in den meisten Fällen nur die Länge, reduziert wird,
- durch Rundung auf Halb- bzw. Ganzgrößen bei der Überführung von einem in ein anderes Größensystem Ungenauigkeiten entstehen und
- die Standardisierung, d. h. die Benennung der Schuhgröße eines bestimmten Modells durch den jeweiligen Hersteller selbst und höchst unterschiedlich durchgeführt wird.

Aufgrund dieser Einschränkungen der verwendeten Standardisierungsverfahren für Schuhgrößen, werden heute auf dem im Markt in großem Umfang Schuhe angeboten, welche trotz gleicher Schuhgrößenbezeichnung stark unterschiedliche Schuhinnenformen aufweisen.

Es hat zahlreiche Versuche gegeben, um die Auswahl einer passenden Schuhgröße eines gewünschten Schuhmodells durch den Kunden zu verbessern. Die Verfahren und Methoden lassen sich in die zwei folgenden Ansätze untergliedern:
Ansatz a): der individuelle Vergleich zwischen dem Fuß des Kunden und den angebotenen Schuhmodellen,
Ansatz b): die numerische Beschreibung von Füßen und Schuhen mittels "Schuhgrößen" oder anderen Kategorien und deren klassenweise Zuordnung.

Ein anschauliches Beispiel für den Ansatz a) ist das im Internet-Shop für Kinderschuhe der Firma "Ricosta", Donaueschingen, verwendete Verfahren (siehe auch: www.ricosta.de/ricosta-welt/fussmessung-online). Hierbei wird zum Zweck eines graphisch-visuellen Vergleichs der nackte Kinderfuß auf den Flachbildbildschirm des Internetrechners des Kunden gestellt bzw. davor gehalten. Zuvor wird der Computer-Bildschirm einmalig mit Hilfe einer Kalibrationshilfe geometrisch kalibriert. Auf dem Bildschirm wird anschließend eine in der Länge und der Breite per Maus veränderbare Schablone einer schematischen Fußsohle dargestellt. Der Kunde kann durch zwei Schieberegler die ungefähre Länge und Breite der auf dem Bildschirm dargestellten schematischen Fußsohle des Kinderfußes verändern, und durch rein visuellen Vergleich mit dem vor dem Bildschirm befindlichen Kinderfuß dessen Länge und Breite ermitteln. Diese Angaben werden für die anschließende Bestellung genutzt. Durch diesen direkten Vergleich benötigt dieses Verfahren im Prinzip keine weiteren Angaben wie die Schuhgröße.

Auch die früher gebräuchlichen Verfahren der Röntgen-Beobachtung des Fußskeletts innerhalb eines angezogenen Schuhs lassen sich unter Ansatz a) einordnen. Wegen der hohen Strahlenbelastung werden diese Verfahren jedoch nicht mehr eingesetzt. Es gibt alternative Ansätze, die Lage und Form des Fußes im Innern des Schuhs mit Hilfe von passiven Wärmebildkameras visuell darzustellen, so dass keine schädliche Strahlungsbelastung auftritt (vgl. z.B.: US 6,975,232 B1).

Zu Ansatz a) existieren noch zahlreiche weitere Verfahrensvarianten. Beispielsweise wird der Fuß mit einem Messgerät geometrisch vermessen, und mit den geometrischen Daten der in Frage kommenden Schuhkandidaten verglichen. Diese Systeme werden typischerweise in zwei- und dreidimensionale Fußmessgeräte unterschieden. Die Auswahl passender Schuhe geschieht über einen Vergleich der Messinformationen über den Fuß (z. B.: 2D-Sohlenform, 3D-Fußmodell, etc.) mit den verfügbaren geometrischen Messdaten der für die Produktion der verwendeten Leisten oder der ausgemessenen Schuhinnenräume.

Einen 3D-Vergleich zwischen Fuß und Schuh bietet beispielsweise die kanadische Firma Vorum Research Corporation an (vgl. auch www.vorum.com/english/footware/matching-system.php). Dabei wird die komplette Oberfläche eines Fußes mit Hilfe eines dreidimensionalen Fußscanners statisch vermessen und dann mit vorhandenen dreidimensionalen Leisteninformationen verglichen und bezüglich ihrer Passform bewertet.

Der zweite Ansatz b) betrifft die traditionellen Ansätze zur Klassifizierung von Füßen und Schuhen mittels einer standardisierten Schuhgröße. Dieser Ansatz geht von der Annahme aus, dass mit der Kenntnis der Schuhgröße die Zuordnung eines passenden Schuhmodells über eine Kategorisierung einfach ist.

Beispiele dieses klassischen Ansatzes b) sind die oben beschriebenen, etablierten Schuhgrößensysteme, wie z.B. die US-, UK- oder EU-SchuhgrößenSysteme. Ist die Schuhgröße nicht bekannt, so werden Füße in ihrer Länge und teilweise auch ihrer Breite nach mit einfachen Hilfen (Maßband, Branock-Schieblehre etc.) vermessen, um ihnen eine Schuhgröße und Breite zuzuordnen. Zu einem Fuß mit der Standard-Größe 42 sollten alle mit der Schuhgröße 42 etikettierten Schuhmodelle passen, was in der Praxis jedoch vielfach nicht der Fall ist.

Es verbleibt festzuhalten, dass die Ansätze a) und b) weder im Hinblick auf die erreichbare Pass-Qualität noch im Hinblick auf die vom Kunden gewünschte einfachen Handhabung befriedigend sind. Insbesondere im Versandhandel, wo kein Anprobieren des Schuhwerks möglich ist, kommt es daher zu häufigen Fehlpasssungen und extrem kostspieligen Retouren der Ware. Das Dokument WO 2007/144582 beschreibt ein Verfahren und eine Vorrichtung zur Kategorisierung und Harmonisierung von Kleidungsstücken.

### Zusammenfassung

Es ist eine Aufgabe der Erfindung, eine Vorrichtung und ein Verfahren anzugeben, welche /welches die im Stand der Technik vorhandenen Probleme verringert.

Gemäß einem Aspekt der Erfindung wird ein Verfahren zu Kategorisierung von Kleidungsstücken im Hinblick auf ihre Kleidungsgröße angegeben. Diese Kleidungsgröße, beispielsweise eine Konfektionsgröße bei Oberbekleidung oder eine Schuhgröße bei Schuhen, beschreibt eine Passform und / oder eine Größe des Kleidungsstückes. Jedes Kleidungsstück ist herstellerseitig mit einer bestimmten Hersteller-Kleidungsgröße versehen. Im Rahmen des erfindungsgemäßen Verfahrens wird eine Grundgesamtheit von Kleidungsstücken betrachtet, welche Kleidungsstücke mit unterschiedlicher Hersteller-Kleidungsgröße umfasst. Dabei sind in jener Grundgesamtheit pro Hersteller-Kleidungsgröße jeweils Kleidungsstücke unterschiedlicher Hersteller vorhanden. An einem Kleidungsstück aus dieser Grundgesamtheit wird zunächst zumindest ein Parameter, der die Passform und / oder die Größe des Kleidungsstücks beschreibt, anhand einer an dem betreffenden Kleidungsstück durchgeführten Messung, erfasst. Dieser zumindest eine Parameter wird der Hersteller-Kleidungsgröße des betreffenden Kleidungsstücks zugeordnet. Die beiden Schritte der Erfassung und der Zuordnung werden für eine Mehrzahl von Kleidungsstücken durchgeführt, welche eine identische Hersteller-Kleidungsgröße aufweisen. Dabei werden Kleidungsstücke unterschiedlicher Hersteller bzw. Anbieter berücksichtigt. Mit anderen Worten werden also innerhalb einer Hersteller-Kleidungsgröße, Kleidungsstücke gleicher Größe aber unterschiedlicher Hersteller bzw. Anbieter analysiert. Außerdem werden die beiden Schritte der Erfassung und der Zuordnung für eine Mehrzahl von Kleidungsstücken mit unterschiedlichen Hersteller-Kleidungsgrößen durchgeführt. Im Anschluss wird eine Häufigkeitsanalyse für das Auftreten bestimmter Werte des zumindest einen Parameters für solche Kleidungsstücke durchgeführt, die eine identische Hersteller-Kleidungsgröße aufweisen, aber von unterschiedlichen Herstellern bzw. Anbietern angeboten werden. Diese Häufigkeitsanalyse wird für eine Mehrzahl von Hersteller-Kleidungsgrößen durchgeführt. Im Idealfall liegt somit je eine Häufigkeitsverteilung und eine Häufigkeitsanalyse für jede der untersuchten Hersteller-Kleidungsgrößen vor, wobei die Häufigkeitsanalyse auf der genannten Grundgesamtheit durchgeführt wird, welche Kleidungsstücke unterschiedlicher Hersteller umfasst. Anschließend werden die Kleidungsstücke durch neue Zuweisung einer ggf. von der Hersteller-Kleidungsgröße abweichenden neuen Kleidungsgröße neu kategorisiert. Diese Kategorisierung erfolgt derart, dass den Kleidungsstücken diejenige neue Kleidungsgröße zugewiesen wird, für die der zumindest eine Parameter innerhalb der neu zugewiesenen Kleidungsgröße eine geringere Streuung aufweist, als dies bei der ursprünglichen Hersteller-Kleidungsgröße der Fall war.

Mit anderen Worten erfolgt die Neu-Zuweisung der Kleidungsgröße derart, dass sich die Häufigkeitsverteilung des zumindest einen Parameters für benachbarte neue Kleidungsgrößen weniger stark überlappt, als dies für die ursprünglichen Hersteller-Kleidungsgrößen der Fall war. In der Terminologie der Statistik und der Klassifikation ausgedrückt bedeutet dies, dass die resultierende Häufigkeitsverteilung in den neuen Kleidungsgröße eine verringerte Intra-Klassenvarianz und eine vergrößerte Inter-Klassenvarianz aufweist. Die Klasse ist in diesem Fall die neue Kleidungsgröße.

Vorteilhaft kann mit Hilfe des Verfahrens zur Kategorisierung von Kleidungsstücken der negative Einfluss auf die Passform in Folge von trotz gleicher Hersteller-Kleidungsgröße vorhandenen Passformabweichungen bei gleichen oder ähnlichen Kleidungsstücken unterschiedlicher Hersteller verringert werden. Anstatt an der ursprünglichen Hersteller-Kleidungsgröße kann sich der Verbraucher an der neu zugewiesenen Kleidungsgröße orientieren. Dies ist insbesondere für den Online-Versandhandel vorteilhaft, da auf diese Weise dem Verbraucher mit größerer Wahrscheinlichkeit ein passendes Kleidungsstück geliefert und somit die Anzahl der Retournierungen verringert werden kann. Gleichzeitig kann sich der Verbraucher anhand der ihm geläufigen Kleidungsgröße, wie beispielsweise der Konfektionsgröße oder der Schuhgröße orientieren. Der Verbraucher muss keine weiteren Informationen zur Verfügung stellen oder weitere Eingriffe, wie beispielsweise eine Vermessung oder einen visuellen Vergleich, vornehmen. Durch die vorgenommene Neu-Zuweisung der Kleidungsgröße, welche eine virtuelle "UmEtikettierung" darstellt, kann dem Verbraucher mit deutlich größerer Wahrscheinlichkeit ein Kleidungsstück geliefert werden, welches der von ihm erfahrungsgemäß angenommenen Passform entspricht, die sich für ihn hinter der betreffenden Kleidungsgrößenangabe verbirgt.

Stark vereinfacht dargestellt, beruht das Verfahren gemäß Aspekten der Erfindung auf der Auswertung der folgenden Erkenntnisse. Im modernen elektronischen Versandhandel wird ein bestimmtes Kleidungsstück von einer großen Zahl N unterschiedlicher Hersteller angeboten. Trotz grundsätzlich gleicher Geometrien unterscheiden sich die Kleidungsstücke relativ stark, obwohl sie mit identischer Hersteller-Kleidungsgröße versehen sind. Typisch bieten N > 20 verschiedene Hersteller ein bestimmtes Kleidungsstück in den üblichen Kleidungsgrößen an. Die Grundgesamtheit N ist groß genug, um über Messungen statistisch gesicherte Erkenntnisse und Systematiken über diese von Hersteller zu Hersteller stark unterschiedlichen Hersteller-Kleidungsgrößen zu gewinnen. Es konnte anhand empirischer Untersuchungen nachgewiesen werden, dass jeweils für ein bestimmtes Kleidungsstück aus der Produktion der N Hersteller mit ihren jeweils eigenen Hersteller-Kleidungsgrößen der Schwerpunkt einer Häufigkeitsverteilung von physikalisch messbaren Abmessungen in der Nähe einer "echten" Kleidungsgröße liegt. Diese "echte" Kleidungsgröße entspricht der Passform und Größe, welche der Kunde von dieser Kleidungsgröße erwartet. Gemäß Aspekten der Erfindung werden diese Erkenntnisse genutzt, um über eine virtuelle Um-Etikettierung, d. h. eine Neuzuordnung der Kleidungsgröße, den Kunden mit Kleidungsstücken zu beliefern, welche trotz der grundsätzlich unsicheren Hersteller-Kleidungsgröße im Durchschnitt besser passen.

Vorteilhaft kann bei dem Verfahren zur Kategorisierung von Kleidungsstücken eine die Häufigkeitsverteilung charakterisierende statistische Kennzahl, beispielsweise ein Percentil-Wert oder ein Mittelwert, des zumindest einen Parameters aus der jeweiligen Häufigkeitsverteilung für die Mehrzahl von Hersteller-Kleidungsgrößen bestimmt werden. Für den Fall, dass mehrere Parameter erfasst werden, werden aus den entsprechenden Häufigkeitsverteilungen mehrere statistische Kennzahlen bestimmt. Die zumindest eine statistische Kennzahl wird einer entsprechenden neuen Kleidungsgröße zugewiesen. Außerdem kann eine Abweichung des zumindest einen Parameters von der entsprechenden statistischen Kennzahl des Parameters für unterschiedliche Hersteller-Kleidungsgrößen bestimmt werden. Dem Kleidungsstück wird diejenige neue Kleidungsgröße zugewiesen, für die diese Abweichung minimal ist.

Außerdem kann die Erfassung der die Passform und/oder die Größe beschreibenden Parameter an gleichen oder ähnlichen Kleidungsstücken unterschiedlicher Hersteller durchgeführt werden. Beispielsweise kann der oder die Parameter an einem bestimmten Typ von Kleidungsstück, beispielsweise einem Herrensakko oder einer Damenstiefelette, unterschiedlicher Hersteller durchgeführt werden. Eine Kategorisierung kann anschließend für alle gleichen oder ähnlichen Kleidungsstücke des entsprechenden Herstellers vorgenommen werden. Auf diese Art und Weise fließt eine Information wie z.B.: der Herrenhalbschuh Typ A des Herstellers B fällt in der Schuhgröße 42 klein aus und entspricht seiner Innenform nach eher der Schuhgröße 41, gewonnen und genutzt werden, um alle Herrenhalbschuhe vom Typ A des Herstellers B neu zu kategorisieren, und diesen Schuhen die neue Schuhgröße 41 anstatt der Hersteller-Achuhgröße 42 zuzuweisen.

Gemäß einer weiteren Ausführungsform betrifft das Verfahren die Kategorisierung von Schuhen. Die Hersteller-Kleidungsgröße ist in diesem Fall die herstellerseitig vergebene Hersteller-Schuhgröße. Zur Verringerung eines negativen Einflusses auf die Passform in Folge von trotz gleicher Hersteller-Schuhgrößen bestehenden Innenformabweichungen kann in einem ersten Schritt eine Innenform eines Schuhes erfasst werden. Dieser Schritt kann beispielsweise mit Hilfe eines Schuhinnenraumscanners durchgeführt werden. Anschließend wird zumindest ein Parameter bestimmt, der die Schuhinnenraumabmessung beschreibt. Dieser zumindest eine Parameter wird der Herstellerschuhgröße zugeordnet. Diese beiden Schritte werden für gleiche oder ähnliche Schuhmodelle aus der Produktion unterschiedlicher Hersteller und für unterschiedliche Herstellerschuhgrößen durchgeführt. Anschließend wird eine Häufigkeitsanalyse für das Auftreten bestimmter Werte des zumindest einen Parameters für Schuhe unterschiedlicher Hersteller mit identischer Hersteller-Schuhgröße durchgeführt. Außerdem werden Häufigkeitsanalysen für die Schuhe in den verschiedenen Hersteller-Schuhgrößen, jedoch für unterschiedliche Hersteller bzw. Anbieter durchgeführt. Eine Kategorisierung der Schuhe erfolgt durch erneutes Zuweisen der Schuhgrößen, wobei den Schuhen eine neue Schuhgröße derart zugewiesen wird, dass die Parameter der mit der neuen Schuhgröße versehenen Schuhe innerhalb dieser neuen Schuhgröße eine geringere Streuung aufweisen als bei der originären Hersteller-Schuhgröße. Auch in diesem Fall überlappen sich anschließend die Häufigkeitsverteilungen der Parameter benachbarter neuer Schuhgrößen weniger stark als dies bei den originären Hersteller-Schuhgrößen der Fall ist.

Eine Anwendung des Verfahrens zur Kategorisierung von Schuhen ist besonders vorteilhaft, da für Schuhe kein genormtes und einheitliches Schuhgrößensystem vorhanden ist.

Gemäß einer weiteren vorteilhaften Ausführungsform wird pro Schuhmodell, pro Herstellerschuhgröße und pro Hersteller zumindest ein Schuh repräsentativ für dieses Schuhmodell und für diesen Hersteller und dessen Schuhgröße mit einem Schuhinnenraumscanner vermessen. Die die Schuhinnenraumabmessung beschreibenden Parameter umfassen dabei zumindest eine anatomisch wichtige Größe. Im Rahmen einer durchgeführten Häufigkeitsanalyse wird eine eindimensionale Häufigkeitsfunktion für die ausgewählte anatomisch wichtige Größe gebildet. Eine Zugehörigkeitsfunktion wird festgelegt. Diese definiert einen Wertebereich für die ausgewählte anatomische Größe. Innerhalb dieses Wertebereiches befinden sich diejenigen, die anatomisch wichtige Größe charakterisierenden Werte, welche bei den meisten Herstellern übereinstimmen. Mit anderen Worten befindet sich die überwiegende Anzahl der Werte, welche bei den meisten Herstellern übereinstimmen, innerhalb dieses Wertebereichs. Dabei kann die Zugehörigkeitsfunktion anhand eines Schwellenwerts von beispielsweise 50% oder 90% festgelegt werden. Die Zugehörigkeitsfunktion wird der neuen Schuhgröße zugewiesen. Anschließend wird eine Kategorisierung der Schuhe durch Neuzuweisung der Schuhgröße durchgeführt. Diese Neuzuweisung erfolgt derart, dass eine neue eindimensionale Häufigkeitsfunktion für Schuhe innerhalb der neuen Schuhgröße und für alle betrachteten Hersteller eine geringere Streuung aufweist als die ursprüngliche eindimensionale Häufigkeitsfunktion.

Eine anatomisch wichtige Größe kann beispielsweise die Innenraumlänge, der Ballenumfang, der Großzehwinkel, die Fersenhöhe, das Höhenprofil des Fußbettes usw. sein. Entsprechend ist es möglich, mehrdimensionale Häufigkeitsverteilungen zu betrachteten.

Gemäß einer weiteren Ausführungsform wird pro Schuhmodell, pro Hersteller-Schuhgröße und pro Hersteller mindestens ein Schuh mit Hilfe eines Schuhinnenraumscanners vermessen, wobei aus diesen Messungen n>=2 Innenraumabmessungen extrahiert werden. Pro Schuhgröße wird entsprechend und für alle Hersteller eine n-dimensionale Häufigkeitsfunktion der n ausgewählten anatomischen Größen gebildet. Ein Maximum dieser n-dimensionalen Häufigkeitsfunktion wird bestimmt und eine n-dimensionale Zugehörigkeitsfunktion wird festgelegt, welche denjenigen Wertebereich der n-anatomischen Größen definiert, der bei den meisten Herstellern für die betrachtete Herstellerschuhgröße übereinstimmt. Wiederum können zur Definition der n-dimensionalen Zugehörigkeitsfunktion entsprechende Grenzwerte herangezogen werden, wobei für jede Dimension ein individueller Grenzwert bestimmt werden kann. Anschließend wird die Schuhgröße neu festgelegt, sodass die n Innenraumabmessungen innerhalb der neu festgelegten Schuhgröße eine geringere Streuung aufweisen als dies bei den originären Herstellerschuhgrößen der Fall war.

Vorteilhaft kann das Verfahren zur Kategorisierung von Kleidungsstücken außerdem für Schutzkleidung oder medizinische, an den Körper angepasste Teile, beispielsweise Stützen, Schienen oder Protektoren, eingesetzt werden.

Besonders vorteilhaft, insbesondere im Hinblick auf einen Einsatz im Online-Versandhandel, ist ein Verfahren zur Auswahl von Schuhwerk mit verbesserter Passform. Bei diesem Verfahren gemäß einem weiteren Aspekt der Erfindung, werden die Schuhe zunächst gemäß dem Verfahren zur Kategorisierung von Kleidungsstücken im Hinblick auf die Schuhgröße neu kategorisiert. Einem Benutzer wird auf Anfrage einer bestimmten Schuhgröße insbesondere solches Schuhwerk angeboten, dessen neue Schuhgröße der Anfrage des Benutzers entspricht. Mit anderen Worten bekommt der Benutzer solches Schuhwerk angeboten, dessen die tatsächliche Passform beschreibende Parameter am ehesten dem entsprechen, was er hinter der betreffenden Schuhgröße vermutet. Die Wahrscheinlichkeit dem Benutzer passendes Schuhwerk anzubieten, kann erhöht werden.

Gemäß einem weiteren Aspekt der Erfindung wird eine Vorrichtung zur Kategorisierung von Kleidungsstücken im Hinblick auf ihre Kleidungsgröße angegeben. Die Vorrichtung umfasst zumindest einen Scanner zur Erfassung zumindest eines Parameters, der die Passform und/oder die Größe eines Kleidungsstückes beschreibt. Die Vorrichtung ist dazu ausgelegt eine Grundgesamtheit zu betrachten, welche Kleidungsstücke mit unterschiedlicher Hersteller-Kleidungsgröße umfasst. In dieser Grundgesamtheit sind Kleidungsstücke unterschiedlicher Hersteller bzw. Anbieter in jeder der Hersteller-Kleidungsgrößen vorhanden. Außerdem umfasst die Vorrichtung eine Verarbeitungseinheit, welche dazu ausgelegt ist, den zumindest einen erfassten Parameter der Hersteller-Kleidungsgröße zuzuordnen. Ferner ist die Verarbeitungseinheit dazu ausgelegt, eine Häufigkeitsanalyse für das Auftreten bestimmter Werte des zumindest einen Parameters für Kleidungsstücke unterschiedlicher Hersteller, die jedoch eine identische Hersteller-Kleidungsgröße aufweisen, durchzuführen. Diese Häufigkeitsanalyse wird außerdem für eine Mehrzahl von Herstellerkleidungsgrößen durchgeführt. Schließlich werden die Kleidungsstücke durch erneute Zuweisung der Kleidungsgröße kategorisiert. Dabei wird den Kleidungsstücken die neue Kleidungsgröße derart zugewiesen, dass die Parameter der mit der neuen Kleidungsgröße versehenen Kleidungsstücke innerhalb der neu zugewiesenen Kleidungsgröße eine geringere Streuung aufweisen innerhalb der ursprünglichen Hersteller-Kleidungsgröße.

Die Vorrichtung zur Kategorisierung von Kleidungsstücken gemäß Aspekten der Erfindung ist insbesondere dazu ausgelegt Schuhe zu kategorisieren. Insofern kann es sich bei dem Scanner bevorzugt um einen Scanner zur Erfassung einer Innenform von Schuhen handeln, welcher ferner dazu ausgelegt sein kann, zumindest einen Parameter zu bestimmen, der die Schuhinnenraumabmessung beschreibt. Dieser Parameter wird seitens der Verarbeitungseinheit der Hersteller-Schuhgröße zugeordnet. Eine Häufigkeitsanalyse für das Auftreten bestimmter Werte des zumindest einen Parameters für Schuhe mit identischer Hersteller-Schuhgröße wird anschließend durchgeführt. Eine Kategorisierung der Schuhe erfolgt durch erneute Zuweisung der Schuhgröße, wobei den Schuhen eine neue Schuhgröße derart zugewiesen wird, dass die Parameter der mit der neuen Schuhgröße versehenen Schuhe innerhalb dieser neuen Schuhgröße eine geringere Streuung aufweisen als bei der originären Hersteller-Schuhgröße.

Gemäß einem weiteren Aspekt der Erfindung wird eine Vorrichtung zur Auswahl von Schuhwerk mit verbesserter Passform angegeben. Diese umfasst eine Vorrichtung zur Kategorisierung von Kleidungsstücken gemäß Aspekten der Erfindung und außerdem eine Eingabeeinheit und eine Ausgabeeinheit. Die Eingabeeinheit ist dazu ausgelegt, Informationen über eine von einem Benutzer gewünschte Schuhgröße zu empfangen. Die Verarbeitungseinheit ist dazu ausgelegt, dem Benutzer über die Ausgabeeinheit Informationen über Schuhwerk anzubieten, deren neue Schuhgröße der von dem Benutzer gewünschten Schuhgröße entspricht.

Gleiche und ähnliche Vorteile, wie sie bereits im Hinblick auf das Verfahren gemäß Aspekten der Erfindung erwähnt wurden, treffen in gleicher oder ähnlicher Weise auf die Vorrichtungen gemäß Aspekten der Erfindung zu und sollen daher nicht wiederholt werden.

### Kurzbeschreibung der Zeichnungen

Im Folgenden wird die Erfindung unter Bezugnahme auf die Zeichnungen, welche bevorzugte Ausführungsbeispiele erläutern, näher beschrieben. Es zeigt:
FIG. 1 eine Häufigkeitsverteilung der Schuhinnenlänge für Damenstiefeletten verschiedener Hersteller und verschiedener Hersteller-Schuhgrößen,
FIG. 2 ausgewählte Häufigkeitsverteilungen (FIG. 2A) und deren Zugehörigkeitsfunktionen (FIG. 2B),
FIG. 3 eine zweidimensionale Häufigkeitsverteilung für eine Schuhinnenlänge und einen Ballenumfang für Damenstiefeletten verschiedener Hersteller und verschiedener Hersteller-Schuhgrößen und
FIG. 4 einzelne Messpunkte der Häufigkeitsverteilung aus FIG. 3 in einem 2D-Plot (FIG. 4A), die Bestimmung von Zugehörigkeitsfunktionen unter Verwendung von Methoden der Clusterbildung (FIG.4B) und eine schematische Illustration einer anschließende Neuzuweisung von Schuhgrößen auf der Basis einer statistischen Analyse der ermittelten Häufigkeitsverteilungen (FIG. 4C).

### Detaillierte Beschreibung

Im Folgenden soll die Durchführung eines Verfahrens gemäß einem Ausführungsbeispiel, beispielhaft für das Schuhmodell "Damenstiefelette" beschrieben werden. Zum Zeitpunkt der Untersuchung wurde dieser Typ Schuh von 51 unterschiedlichen Herstellern in verschiedenen Größen und Ausführungsvarianten in einem Internetshop angeboten. Die umfangreichen Untersuchungen der Innenraumabmessungen wurden mit einem optisch und zerstörungsfrei arbeitenden Schuh-Innenraum Scanner, welcher beispielsweise in der WO 2009 / 006989 A1 beschrieben ist, an 874 Schuhen durchgeführt. Die Messungen haben gezeigt, dass das von verschiedenen Schuhproduzenten hergestellte gleiche Schuhmodell bei gleicher Hersteller-Größenangabe, d. h. etikettierter Schuhgröße, stark unterschiedliche Schuhinnenlängen aufweist. Alternativ zur expliziten Vermessung können die benötigten Innenraum-Abmessungen auch aus benachbarten vermessenen Größen der gleichen Schuhmodelle gradiert werden, sofern verlässige Gradierungsverfahren für die betroffenen Schuhmodelle vorliegen.

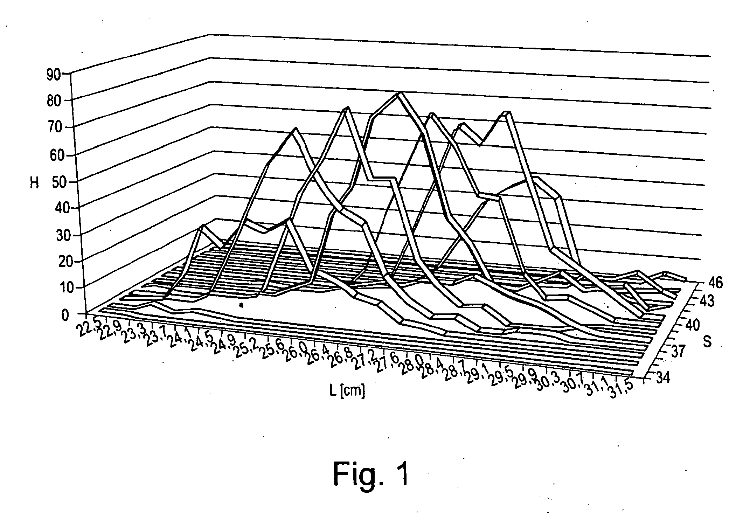

FIG. 1 zeigt eine Häufigkeitsverteilung der mit dem Innenraum-Scanner gemessenen Schuhinnenlängen L für Damen-Stiefeletten mit den Schuhgrößen S von EU 36 bis EU 41, hergestellt von 36 verschiedenen Schuhproduzenten. Die Streuung der Häufigkeit H der gemessenen Schuhinnenlängen L weicht bei den verschiedenen Herstellern um bis zu drei EU-Schuhgrößen ab. Bei diesen Untersuchungen konnte außerdem festgestellt werden, dass die eigentlichen Produktionstoleranzen vernachlässigbar sind gegenüber der unsystematischen Etikettierung der verschiedenen Hersteller. Passformschwierigkeiten sind als weitestgehend auf ungenaue Herstellergrößenangaben zurückzuführen. Insofern ist es gemäß einem weiteren Ausführungsbeispiel möglich, einen Schuh repräsentativ für eine Schuhgröße eines bestimmten Herstellers zu vermessen und für die entsprechend etikettierten Schuhe dieses Herstellers einen gleichen oder identischen Parameter anzunehmen. Mit anderen Worten kann davon ausgegangen werden, dass alle Schuhe eines bestimmten Typs, einer bestimmten Hersteller-Schuhgröße und eines bestimmten Herstellers eine nahezu gleiche Schuhinnenlänge L aufweisen.

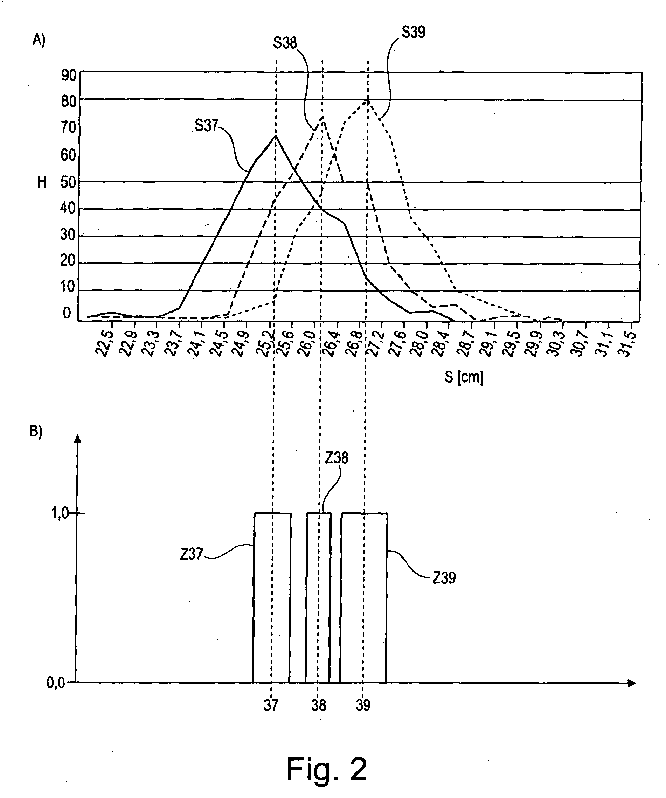

FIG. 2A zeigt die Verteilung der Häufigkeit H der Schuhinnlänge L der Damen-Stiefeletten für die drei Schuhgrößen EU 37 (Kurve S37), EU 38 (Kurve S38) und EU 39 (Kurve S39) für Schuhe unterschiedlicher Hersteller. Die Häufigkeitsverteilungen S37, S38, S39 überlappen sich deutlich, die gemessene Schuhinnenlänge S streut über mehrere benachbarte Schuhgrößen. Aus der eindimensionalen Häufigkeitsverteilung für jede der Schuhgrößen kann jeweils eine binäre Zugehörigkeitsfunktion bestimmt werden. Diese zeigt FIG. 2B. Dabei bezeichnet Z37 die Zugehörigkeitsfunktion für die Schuhgröße EU 37, Z38 die Zugehörigkeitsfunktion für die Schuhgröße EU 38 und Z39 die Zugehörigkeitsfunktion für die Schuhgröße EU 39. Der Mittelpunkt der Zugehörigkeitsfunktionen Z37, Z38, Z39 kann anhand des Mittelpunktes der entsprechenden Häufigkeitsverteilungen S37, S38 bzw. S39 bestimmt und am Maximum der jeweiligen Häufigkeitsverteilung S37, S38, S39 zentriert werden.

Die Breite der Zugehörigkeitsfunktionen Z37, Z38, Z39, welche für alle Zugehörigkeitsfunktionen gleich sein kann, kann so gewählt werden, dass die am häufigsten vorkommenden Schuhinnenlängen L der entsprechenden Schuhgröße innerhalb der Zugehörigkeitsfunktion Z37, Z38, Z39 liegen. Beispielsweise kann die Breite der Zugehörigkeitsfunktion Z37, Z38, Z39 so gewählt werden, dass zumindest 50% oder 90% der Schuhe der entsprechenden Schuhgröße innerhalb der jeweiligen Zugehörigkeitsfunktion liegen. Selbstverständlich können die Breite der Zugehörigkeitsfunktionen Z37, Z38, Z39 und der Grenzwert beliebig und anhand der jeweils gemessenen Verteilung der Häufigkeit H festgelegt werden. Es kann für jede Hersteller-Schuhgröße im Angebot eine solche Zugehörigkeitsfunktion bestimmt werden. Die neue Schuhgröße 37 umfasst nun beispielsweise alle Schuhinnenlängen L von 23,7 cm (linker Rand) bis zur Mitte des Intervalls zwischen der Zugehörigkeitsfunktion Z37 und Z38 der neuen Schuhgröße 38, im Beispiel 26,0 cm. Die neue Schuhgröße 38 umfasst Schuhinnenlängen L von 26,1 cm bis 26,8 cm und die neue Schuhgröße 39 umfasst Schuhinnenlängen L von 26,9 cm bis 30,7 cm.

Anschließend erfolgt eine Neuzuweisung der Schuhgröße. Anhand der gemessenen Schuhinnenlängen L werden Ausreißer der jeweils benachbarten Schuhgröße zugeschlagen, wobei als Kategorien dieser Neu-Kategorisierung die Bezeichnung der Herstellerschuhgrößen, also z.B. EU 37, EU 38 usw. beibehalten werden. Durch diese virtuelle Um-Etikettierung der Schuhe, welche beispielsweise unter Zuhilfenahme einer entsprechenden Datenbank erfolgen kann, werden die Schuhinnenlängen L innerhalb der neuen Schuhgröße homogenisiert, die Überlappung der Häufigkeitsverteilungen benachbarter Schuhgrößen sinkt.

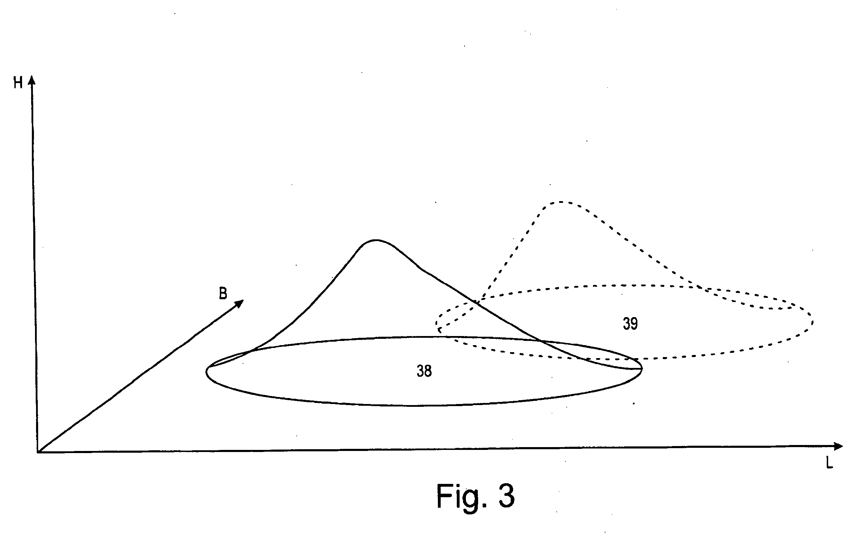

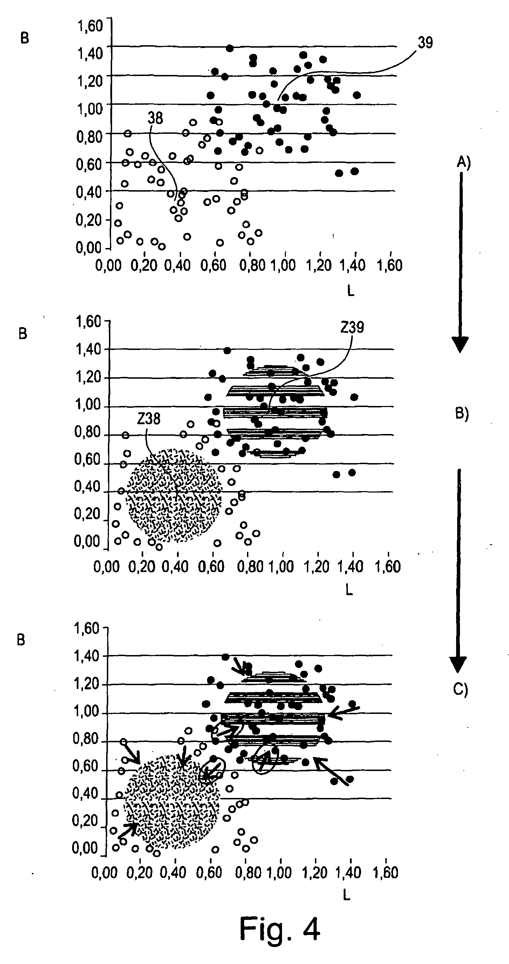

In FIG. 3 ist eine zweidimensionale Häufigkeitsverteilung für zwei anatomisch wichtige Größen, nämlich die Schuhinnenlänge L und den Ballenumfang B. Die Häufigkeit H ist in einem 2D-Plot für die Schuhgrößen EU 38 und EU 39 aufgetragen. Gemäß einem Ausführungsbeispiel soll ein Verfahren zur Kategorisierung der entsprechenden Schuhe unter Verwendung dieser zweidimensionalen Häufigkeitsverteilung anhang von FIG. 4 erläutert werden.

FIG. 4A zeigt die einzelnen Messergebnisse für die Schuhinnenlänge L und den Ballenumfang B in einem Streu-Diagramm, d.h. der Projektion des 2D-Histogramms auf eine Grundfläche. Jeder punktförmige Eintrag entspricht dem Innenmaße-Paar aus Schuhinnenlänge L und Ballenumfang B einer Stiefelette der betrachteten Schuhgrößen und für einen der beispielhaft betrachteten 51 Hersteller. Die Wertepaare für die Hersteller-Schuhgröße EU 38 sind durch offene Kreise, die für die Hersteller-Schuhgröße EU 39 durch geschlossene Kreise dargestellt. Die große Streuung und Überlappung der Häufigkeitsverteilungen sind deutlich erkennbar. Aus Gründen der Übersichtlichkeit ist die Darstellung auf zwei Hersteller und auf die Schuhgrößen EU 38 und EU 39 begrenzt. In FIG. 4B sind zweidimensionale Zugehörigkeitsbereiche Z38 und Z39 anhand der am häufigsten vorkommenden Wertepaare für die Schuhinnenlänge L und den Ballenumfang B für jede der Schuhgrößen EU 38 und EU 39 definiert worden. Beispielhaft sind die Zugehörigkeitsbereiche Z38, Z39 kreisförmig gewählt. Selbstverständlich ist auch jede andere geeignete Form für die Zugehörigkeitsbereiche Z38, Z39 möglich.

Anschließend kann eine Kategorisierung der Schuhe durchgeführt werden. Dies ist in FIG. 4C gezeigt. Den Schuhen können mit Hilfe der Zugehörigkeitsbereiche neuen Schuhgrößen so zugeordnet werden, dass die resultierende Häufigkeitsverteilung in diesen neuen Schuhgrößen eine verringerte Intra-Klassenvarianz und eine vergrößerte Inter-Klassenvarianz aufzeigen. In diesem Zusammenhang wird die Schuhgröße als Klasse betrachtet. Dies kann durch zwei Agglomerations-Schritte erreicht. Für alle Wertepaare innerhalb eines Zugehörigkeitsbereiches wird die Schuhgröße beibehalten. Die Wertepaare außerhalb des Zugehörigkeitsbereiches werden dem am nächsten liegenden Zugehörigkeitsbereich zugeschlagen und gegebenenfalls neu zugeordnet. So werden alle mit einem nicht umrandeten Pfeil gezeichneten Wertepaare einer neuen Schuhgröße zugeordnet, die der bisherigen Hersteller-Schuhgröße entspricht. Die mit einem umrandeten Pfeil gekennzeichneten Wertepaare werden einer neuen Schuhgröße zugeordnet, welche von der ursprünglichen Hersteller-Schuhgröße abweicht. Die Zuordnung der neuen Schuhgröße kann beispielsweise erfolgen, indem ein Abstand des Wertepaars zu einem Schwerpunkt oder Maximum (vgl. auch FIG. 3) der benachbarten Schuhgrößen berechnet wird. Das entsprechende Wertepaar wird nun derjenigen Schuhgröße zugeschlagen, zu welcher der Abstand am geringsten ist.

Es ist dem Fachmann der Statistik und insbesondere der Cluster-Analyse und Klassifikation bekannt, die Innenform-Parameter wie Schuhinnenlänge L und Ballenumfang B durch weitere anatomisch für die Passform entscheidende Innenmaße, wie beispielsweise den Großzehwinkel, die Fersenhöhe, das Höhenprofil des Fußbettes usw. zu ergänzen, und die beschriebenen Häufigkeitsfunktionen in entsprechend höher dimensionalen Werteräumen auszuwerten.

Mit einer Vorrichtung zur Kategorisierung von Kleidungsstücken gemäß einem weiteren Ausführungsbeispiel kann die oben beschriebene Neuzuweisung der Schuhgröße automatisch erfolgen, wobei beispielsweise mit Hilfe einer Datenbank die Hersteller-Schuhgrößen verschiedener Hersteller "virtuell um-etikettiert" werden. Dies ist insbesondere für den Online-Versandhandel vorteilhaft, wie im Folgenden beispielhaft erläutert werden soll:

Eine Kundin bestellt im Versandhandel ein Paar Damen-Stiefeletten; sie kennt ihre übliche Schuhgröße (beispielsweise EU 38) aus früheren Bestellungen oder von ihrem passenden Schuhwerk. Der Versandhandel hat Damen-Stiefeletten verschiedener Hersteller im Angebot. Diese können sich bei gleicher etikettierter Schuhgröße in Material, Farbgebung, modischem Accessoire, Preis usw. unterscheiden. Die Kundin möchte aus diesem Angebot einen passenden Schuh gemäß ihrer Schuhgröße EU 38 bestellen. Die von den Herstellern verwendeten Schuhgrößen sind aufgrund der Etikettierungs-Eigenarten der jeweiligen Hersteller bzw. derer Leistenhersteller stark unterschiedlich. Aufgrund der bereits durchgeführten Kategorisierung ist dem Versandhandel jedoch bekannt, dass bei den verschiedenen Herstellern die etikettierte Hersteller-Schuhgröße EU 38 sehr unterschiedlich im Hinblick auf die tatsächliche Schuhform und deren Innenraum-Abmessungen ausfällt. Es sind daher zahlreiche Passprobleme zu erwarten, wenn die Kundin ein Modell lediglich entsprechend ihrem Suchkriterium: "Schuhgröße EU 38" bestellt.

Gemäß einem Ausführungsbeispiel hat der Versandhändler jedoch alle Damen-Stiefeletten seiner verschiedenen Hersteller mit Hilfe eines 3D-Innenraumscanners geometrisch ausgemessen und hieraus eine Statistik (über alle Hersteller hinweg) der tatsächlich vorkommenden Innenformen für jede etikettierte Hersteller-Schuhgröße ermittelt. Die Innenform der Schuhe beschreibt der Händler vorzugsweise durch Maße wie die Schuhinnenlänge L, den Ballenumfang B etc.. Dem Händler liegt also eine Häufigkeitsverteilung vergleichbar den FIG. 1, 2A oder 3 vor.

Erfindungsgemäß werden diese Histogramme der Schuhinnenlängen L wie folgt genutzt: Die Bereiche um die Maxima sind die am häufigsten vorkommenden Schuhinnenlängen L für eine gegebene Schuhgröße (über alle Hersteller hinweg). Bei der Auswahl eines Schuhs anhand der stark streuenden Hersteller-Schuhgröße ist für den bestellenden Kunden die Wahrscheinlichkeit am größten, auf eine Schuhinnenlänge L im Bereich des Histogramm-Maximums zu treffen. Also werden diese Regionen maximaler Häufigkeit als der Bereich der Schuhinnenlänge L definiert, bei welcher die Standard-Schuhgröße des Kunden am wahrscheinlichsten mit der vom Hersteller etikettierten Schuhgröße zusammenpasst. Schuhinnenlängen L außerhalb dieser Bereiche maximaler Häufigkeit werden vom Versandhandel virtuell in benachbarte Schuhgrößen um-etikettiert, und diese umetikettierte Größen werden für die Auswahl des am besten passenden Schuhs genutzt.

Ein besonderer Vorteil des Verfahrens ist es, dass trotz der Verbesserung der erreichbaren Passform-Rate der Aufwand auf der Seite des bestellenden Kunden sich nicht erhöht. Der Kunde benötigt keine zusätzlichen anatomischen Merkmale seines Fußes über die klassische Schuhgröße hinaus. Der zu betreibende Aufwand verbleibt beim Versandhandel, welcher das erfindungsgemäße Verfahren in seinen elektronischen Bestellvorgang integrieren kann.

Es bleibt dem Versandhandel überlassen, ob er die durchgeführte Kategorisierung dem Kunden kommuniziert, beispielsweise durch Angaben wie: "Wir empfehlen Ihnen, bei Ihrer Schuhgröße "38" und diesem Hersteller X eine Schuhgröße "39" zu bestellen" oder ob die Auswahl des passenden Schuhs anhand der um-etikettierten Schuhgrößen für den Besteller unsichtbar bleibt.

Das Verfahren gemäß Aspekten der Erfindung ist nicht auf den Schuhversandhandel begrenzt. Es ist ebenso vorteilhaft im konventionellen Schuhverkauf, d. h. im Schuhgeschäft, einsetzbar, um die Anzahl der potentiell passenden Schuhe vor dem eigentlichen Anprobieren zu verringern und damit den Verkaufsvorgang zu beschleunigen. Die Zuweisung der Schuhgrößen kann mit Hilfe einer Datenbank vor Ort oder mit Hilfe einer ausgelagerten Datenbank, beispielsweise einer Zuweisungstabelle, erfolgen und die Auswahl der möglicherweise passenden Schuhe positiv einschränken.

Das Verfahren gemäß Aspekten der Erfindung ist nicht auf die Auswahl von Schuhwerk beschränkt, sondern lässt sich vorteilhaft in ähnlicher Weise auch für den Bekleidungshandel einsetzen. Auch hier ist das Problem bekannt, dass Hersteller-Kleidergrößen in unsystematischer Weise vergeben werden, schwanken und wenig konsistent mit Standardgrössen sind. Anstelle eines Schuhinnenraum-Scanners kann ein Körperscanner benutzt werden, um die Häufigkeitsverteilungen der verschiedenen Körpermaße wie Taillenumfang, Beinlänge, Brustumfang etc. zu ermitteln. Mit Hilfe des erfindungsgemäßen Verfahrens kann eine deutlich geringere Streuung innerhalb der neu zugewiesenen Kleidungsgröße und eine deutlich verringerte Überlappung zwischen den verschiedenen Kleidungsgrößen erreicht werden.

## Patentansprüche

1. Verfahren zur Kategorisierung von Kleidungsstücken im Hinblick auf ihre Kleidungsgröße, welche eine Passform und / oder eine Größe des Kleidungsstücks beschreibt, wobei jedes Kleidungsstück mit einer herstellerseitig bestimmten Hersteller-Kleidungsgröße versehen ist, und wobei eine Grundgesamtheit betrachtet wird, welche Kleidungsstücke mit unterschiedlicher Hersteller-Kleidungsgröße umfasst und Kleidungsstücke unterschiedlicher Hersteller in jeder Hersteller-Kleidungsgröße vorhanden sind, wobei das Verfahren die folgenden Schritte umfasst:
a) Erfassen zumindest eines Parameters, der die Passform und / oder die Größe eines Kleidungsstücks beschreibt, anhand einer an dem betreffenden Kleidungsstück durchgeführten Messung,
b) Zuordnen des erfassten Parameters zu der Hersteller-Kleidungsgröße des vermessenen Kleidungsstücks,
c) Durchführen der Schritte a) und b) für eine Mehrzahl von Kleidungsstücken unterschiedlicher Hersteller, welche eine identische Hersteller-Kleidungsgröße aufweisen,
d) Durchführen der Schritte a) bis c) für eine Mehrzahl von unterschiedlichen Hersteller-Kleidungsgrößen,
e) Durchführen eine Häufigkeitsanalyse für das Auftreten bestimmter Werte des zumindest einen Parameters für Kleidungsstücke unterschiedlicher Hersteller, die eine identische Hersteller-Kleidungsgröße aufweisen, wobei die Häufigkeitsanalyse für eine Mehrzahl von Hersteller-Kleidungsgrößen durchgeführt wird,
f) Kategorisieren der Kleidungsstücke durch erneute Zuweisung der Kleidungsgröße, wobei den Kleidungsstücken die neue Kleidungsgröße derart zugewiesen wird, dass der zumindest eine Parameter von mit der neuen Kleidungsgröße versehenen Kleidungsstücken, innerhalb dieser neuen Kleidungsgröße eine geringere Streuung aufweist als der zu der Hersteller-Kleidungsgröße erfasste zumindest eine Parameter.

2. Verfahren zur Kategorisierung von Kleidungsstücken nach Anspruch 1, bei dem eine die Häufigkeitsverteilung charakterisierende statistische Kennzahl für den zumindest einen Parameter aus der jeweiligen Häufigkeitsverteilung für jede der betrachteten Hersteller-Kleidungsgrößen bestimmt und dieser zuweisen wird, und in Schritt f) eine Abweichung des zumindest einen Parameters eines zu kategorisierenden Kleidungsstücks von der entsprechenden statistischen Kennzahl dieses Parameters für Kleidungsstücke unterschiedlicher Hersteller und unterschiedlicher Hersteller-Kleidungsgröße bestimmt wird, und dem Kleidungsstück diejenige neue Kleidungsgröße zugewiesen wird, für die die Abweichung von der statistischen Kennzahl minimal ist.

3. Verfahren zur Kategorisierung von Kleidungsstücken nach Anspruch 2, bei dem die die Häufigkeitsverteilung charakterisierende statistische Kennzahl ein Percentil-Wert der Häufigkeitsverteilung und / oder ein Mittelwert der Häufigkeitsverteilung ist.

4. Verfahren zur Kategorisierung von Kleidungsstücken nach einem der vorhergehenden Ansprüche, bei dem Schritt a) an gleichen oder ähnlichen Kleidungsstücken unterschiedlicher Hersteller durchgeführt wird, wobei jeweils zumindest ein Kleidungsstück repräsentativ für eine Hersteller-Kleidungsgröße eines betrachteten Herstellers vermessen wird, und in Schritt f) eine Kategorisierung für alle Kleidungsstücke der betrachteten Hersteller-Kleidungsgröße des entsprechenden Herstellers vorgenommen wird.

5. Verfahren zur Kategorisierung von Kleidungsstücken nach einem der vorhergehenden Ansprüche, wobei die Kleidungsstücke Schuhe sind, und die Hersteller-Kleidungsgröße eine herstellerseitig vergebene Hersteller-Schuhgröße ist, wobei zur Verringerung eines negativen Einflusses auf die Passform infolge von trotz gleicher Hersteller-Schuhgröße bestehenden Innenform-Abweichungen:
in Schritt a) eine Innenform eines Schuhs erfasst wird, und zumindest ein Parameter, der die Schuhinnenraum-Abmessung beschreibt, bestimmt wird,
in Schritt b) der zumindest eine Parameter der Hersteller-Schuhgröße zugeordnet wird,
die Schritte a) und b) für gleiche oder ähnliche Schuhmodelle aus der Produktion unterschiedlicher Hersteller und für unterschiedliche Hersteller-Schuhgrößen durchgeführt werden,
in Schritt e) eine Häufigkeitsanalyse für das Auftreten bestimmter Werte des zumindest einen Parameters für Schuhe unterschiedlicher Hersteller aber mit identischer Hersteller-Schuhgröße durchgeführt wird,
in Schritt f) eine Kategorisierung der Schuhe durch erneute Zuweisung der Schuhgröße erfolgt, wobei den Schuhen die neue Schuhgröße derart zugewiesen wird, dass der zumindest eine Parameter der mit der neuen Schuhgröße versehenen Schuhe innerhalb der neuen Schuhgröße eine geringere Streuung aufweist als bei der originären Hersteller-Schuhgröße.

6. Verfahren zur Kategorisierung von Kleidungsstücken nach Anspruch 5, bei dem
in Schritt a) pro Schuhmodell und pro Hersteller-Schuhgröße repräsentativ für das Schuhmodell und für die Hersteller-Schuhgröße zumindest ein Schuh mit Hilfe eines Schuhinnenraum-Scanners vermessen wird, und als die Schuhinnenraum-Abmessung beschreibender Parameter zumindest eine anatomisch wichtige Größe erfasst wird,
in Schritt e) eine eindimensionale Häufigkeitsfunktion für die ausgewählte anatomisch wichtige Größe gebildet wird,
eine Zugehörigkeitsfunktion festgelegt wird, welche einen Wertebereich der betreffenden anatomisch wichtigen Größe definiert, und diese Zugehörigkeitsfunktion einer neuen Schuhgröße zugewiesen wird,
in Schritt f) eine Kategorisierung der Schuhe durch erneutes Zuweisen der Schuhgröße derart erfolgt, dass die eindimensionale Häufigkeitsfunktion des Parameters, der die anatomisch wichtige Größe beschreibt, innerhalb der neuen Schuhgröße eine geringere Streuung aufweist als in der originären Hersteller-Schuhgröße.

7. Verfahren zur Kategorisierung von Kleidungsstücken nach Anspruch 5 oder 6, bei dem
in Schritt a) pro Schuhmodell und pro Hersteller-Schuhgröße mindestens ein Schuh mit Hilfe eines Schuhinnenraum-Scanners vermessen wird und aus diesen Messungen n>=2 Innenraumabmessungen, extrahiert werden,
in Schritt d) pro Schuhgröße und pro Hersteller eine n-dimensionale Häufigkeitsfunktion für die n ausgewählten anatomischen Größen gebildet wird,
eine n-dimensionale Zugehörigkeitsfunktion festgelegt wird, welche einen Wertebereich der n anatomischen Größen definiert,
in Schritt f) die Schuhgrößen für alle betrachteten Hersteller neu vergeben werden, so dass die n Innenraumabmessungen innerhalb der neuen Schuhgröße eine geringere Streuung aufweisen als bei den originären Hersteller-Schuhgrößen.

8. Verfahren zur Kategorisierung von Kleidungsstücken nach einem der Ansprüche 1 bis 4, wobei die Kleidungsstücke Schutzkleidung oder medizinische an den Körper angepasste Teile, wie Stützen, Schienen oder Protektoren sind.

9. Verfahren zur Auswahl von Schuhwerk mit verbesserter Passform, bei dem Schuhgrößen gemäß einem Verfahren zur Kategorisierung nach einem der Ansprüche 5 bis 7 neu vergeben werden und einem Benutzer auf Anfrage einer bestimmten Schuhgröße Schuhe angeboten werden, deren neue Schuhgröße der Anfrage des Benutzers entspricht.

10. Vorrichtung zur Kategorisierung von Kleidungsstücken im Hinblick auf ihre Kleidungsgröße, welche eine Passform und / oder eine Größe des Kleidungsstücks beschreibt, wobei jedes Kleidungsstück mit einer herstellerseitig bestimmten Hersteller-Kleidungsgröße versehen ist, und wobei eine Grundgesamtheit betrachtet wird, welche Kleidungsstücke mit unterschiedlicher Hersteller-Kleidungsgröße umfasst und Kleidungsstücke unterschiedlicher Hersteller in jeder Hersteller-Kleidungsgröße vorhanden sind, und wobei die Vorrichtung einen Scanner zur Erfassung zumindest eines Parameters, der die Passform und / oder die Größe eines Kleidungsstücks beschreibt und eine Verarbeitungseinheit umfasst, wobei die Verarbeitungseinheit dazu ausgelegt ist:
a) den zumindest einen erfassten Parameter der Hersteller-Kleidungsgröße zuzuordnen,
b) eine Häufigkeitsanalyse für das Auftreten bestimmter Werte des zumindest einen Parameters für Kleidungsstücke unterschiedlicher Hersteller, die eine identische Hersteller-Kleidungsgröße aufweisen, durchzuführen, und die Häufigkeitsanalyse für eine Mehrzahl von Kleidungsstücken unterschiedlicher Hersteller aber identischer Hersteller-Kleidungsgröße und für verschiedene Hersteller-Kleidungsgrößen durchzuführen,
c) die Kleidungsstücke durch erneute Zuweisung der Kleidungsgröße zu kategorisieren, und den Kleidungsstücken die neue Kleidungsgröße derart zuzuweisen, dass der zumindest eine Parameter der mit der neuen Kleidungsgröße versehenen Kleidungsstücke, innerhalb der neuen Kleidungsgröße eine geringere Streuung aufweisen als bei der ursprünglichen Hersteller-Kleidungsgröße.

11. Vorrichtung zur Kategorisierung von Kleidungsstücken nach Anspruch 10, wobei die Kleidungsstücke Schuhe sind, und die Hersteller-Kleidungsgröße eine herstellerseitig vergebene Hersteller-Schuhgröße ist, und wobei der Scanner ein Scanner zur Erfassung einer Innenform von Schuhen ist und ferner dazu ausgelegt ist, zumindest einen Parameter, der die Schuhinnenraum-Abmessung beschreibt, zu bestimmen, und wobei die Verarbeitungseinheit ferner dazu ausgelegt ist:
in Merkmal a) den zumindest einen Parameter der Hersteller-Schuhgröße zuzuordnen,
in Merkmal b) eine Häufigkeitsanalyse für das Auftreten bestimmter Werte des zumindest einen Parameters für Schuhe unterschiedlicher Hersteller mit identischer Hersteller-Schuhgröße durchzuführen,
in Merkmal c) eine Kategorisierung der Schuhe durch erneute Zuweisung der Schuhgröße vorzunehmen, wobei den Schuhen eine neue Schuhgröße derart zugewiesen wird, dass der zumindest eine Parameter der mit der neuen Schuhgröße versehenen Schuhe innerhalb der neuen Schuhgröße eine geringere Streuung aufweisen als bei der originären Hersteller-Schuhgröße.

12. Vorrichtung zur Auswahl von Schuhwerk mit verbesserter Passform, umfassend eine Vorrichtung zur Kategorisierung von Kleidungsstücken nach Anspruch 11 und eine Eingabe- und eine Ausgabeeinheit, wobei die Eingabeeinheit dazu ausgelegt ist Informationen über eine von einem Benutzer gewünschte Schuhgröße zu empfangen und die Verarbeitungseinheit dazu ausgelegt ist dem Benutzer über die Ausgabeeinheit Informationen über Schuhwerk anzubieten, dessen neue Schuhgröße der von dem Benutzer gewünschten Schuhgröße entspricht.

## Claims

1. A method of categorizing articles of clothing with regard to their clothing size describing a fit and/or a size of the article of clothing, each article of clothing being provided with a manufacturer clothing size determined on the part of the manufacturer, a basic population being considered which comprises articles of clothing having different manufacturer clothing sizes, and articles of clothing of different manufacturers being included in each manufacturer clothing size, the method comprising the following steps:
a) acquiring at least one parameter describing the fit and/or the size of an article of clothing on the basis of a measurement carried out on the article of clothing concerned,
b) assigning the acquired parameter to the manufacturer clothing size of the measured article of clothing,
c) performing the steps a) and b) for a plurality of articles of clothing of different manufacturers having an identical manufacturer clothing size,
d) performing the steps a) to c) for a plurality of different manufacturer clothing sizes,
e) performing a frequency analysis for the occurrence of specific values of the at least one parameter for articles of clothing of different manufacturers having an identical manufacturer clothing size, the frequency analysis being performed for a plurality of manufacturer clothing sizes,
f) categorizing the articles of clothing by a new allocation of the clothing size, the new clothing size being allocated to the articles of clothing in such a manner that the at least one parameter of articles of clothing provided with the new clothing size within this new clothing size has a smaller dispersion than the at least one parameter acquired as to the manufacturer clothing size.

2. The method of categorizing articles of clothing according to claim 1, wherein a statistical key figure characterizing the frequency distribution for the at least one parameter from the respective frequency distribution is determined for each of the manufacturer clothing sizes considered and is allocated thereto, and wherein in step f), a deviation of the at least one parameter of an article of clothing to be categorized from the corresponding statistical key figure of this parameter for articles of clothing of different manufacturers and having different manufacturer clothing sizes is determined, and wherein that new clothing size is allocated to the article of clothing, for which the deviation from the statistical key figure is minimal.

3. The method of categorizing articles of clothing according to claim 2, wherein the statistical key figure characterizing the frequency distribution is a percentile value of the frequency distribution and/or a mean value of the frequency distribution.

4. The method of categorizing articles of clothing according to any of the preceding claims, wherein step a) is performed on identical or similar articles of clothing of different manufacturers, at least one article of clothing being respectively measured representatively for a manufacturer clothing size of a manufacturer considered, and wherein in step f), a categorization is carried out for all articles of clothing of the considered manufacturer clothing size of the corresponding manufacturer.

5. The method of categorizing articles of clothing according to any of the preceding claims, wherein the articles of clothing are shoes and the manufacturer clothing size is a manufacturer shoe size assigned on the part of the manufacturer, wherein, to reduce a negative influence on the fit as a result of inner shape deviations existing despite an identical manufacturer shoe size,
in step a), an inner shape of a shoe is acquired and at least one parameter describing the dimension of the shoe interior is determined,
in step b), the at least one parameter is assigned to the manufacturer shoe size,
steps a) and b) are performed for identical or similar shoe models from the production of different manufacturers and for different manufacturer shoe sizes,
in step e), a frequency analysis for the occurrence of specific values of the at least one parameter is performed for shoes of different manufacturers but having an identical manufacturer shoe size,
in step f), a categorization of the shoes is performed by a new allocation of the shoe size, the new shoe size being allocated to the shoes such that the at least one parameter of the shoes provided with the new shoe size within the new shoe size has a smaller dispersion than in the original manufacturer shoe size.

6. The method of categorizing articles of clothing according to claim 5, wherein
in step a), at least one shoe per shoe model and per manufacturer shoe size is measured in a representative manner for the shoe model and the manufacturer shoe size using a shoe interior scanner, and at least one anatomically relevant quantity is acquired as parameter describing the dimension of the shoe interior,
in step e), a one-dimensional frequency function is formed for the chosen anatomically relevant quantity,
a membership function is fixed, which defines a range of values of the anatomically relevant quantity in question, and this membership function is allocated to a new shoe size,
in step f), a categorization of the shoes is performed by a new allocation of the shoe size, such that the one-dimensional frequency function of the parameter describing the anatomically relevant quantity within the new shoe size has a smaller dispersion than in the original manufacturer shoe size.

7. The method of categorizing articles of clothing according to claim 5 or 6, wherein
in step a), at least one shoe per shoe model and per manufacturer shoe size is measured using a shoe interior scanner, and n >= 2 interior dimensions are extracted from these measurements,
in step d), an n-dimensional frequency function per shoe size and per manufacturer is established for the n chosen anatomical quantities,
an n-dimensional membership function is fixed which defines a range of values of the n anatomical quantities,
in step f), the shoe sizes for all manufacturers considered are reassigned so that the n interior dimensions within the new shoe sizes have a smaller dispersion than in the original manufacturer shoe sizes.

8. The method of categorizing articles of clothing according to any of claims 1 to 4, wherein the articles of clothing are protective clothing or medical parts adapted to the body, such as supports, splints or protectors.

9. A method of selecting footwear having an improved fit, wherein shoe sizes are reassigned in accordance with a method of categorizing according to any of claims 5 to 7, and wherein shoes the new shoe size of which corresponds to a request of a user are offered to the user on request for a specific shoe size.

10. A device for categorizing articles of clothing with regard to their clothing size which describes a fit and/or a size of the article of clothing, each article of clothing being provided with a manufacturer clothing size determined on the part of the manufacturer, and wherein a basic population is considered which comprises articles of clothing having different manufacturer clothing sizes and articles of clothing of different manufacturers are included in each manufacturer clothing size, and wherein the device comprises a scanner for acquiring at least one parameter describing the fit and/or the size of an article of clothing, and a processing unit, the processing unit being adapted:
a) to assign the at least one acquired parameter to the manufacturer clothing size,
b) to perform a frequency analysis for the occurrence of specific values of the at least one parameter for articles of clothing of different manufacturers having an identical manufacturer clothing size, and to perform the frequency analysis for a plurality of articles of clothing of different manufacturers but having an identical manufacturer clothing size, and for different manufacturer clothing sizes,
c) to categorize the articles of clothing by a new allocation of the clothing size and to allocate the new clothing size to the articles of clothing such that the at least one parameter of the articles of clothing provided with the new clothing size within the new clothing size has a smaller dispersion than in the original manufacturer clothing size.

11. The device for categorizing articles of clothing according to claim 10, wherein the articles of clothing are shoes and the manufacturer clothing size is a manufacturer shoe size assigned on the part of the manufacturer, and wherein the scanner is a scanner for detecting an inner shape of shoes and is further adapted to determine at least one parameter describing the dimension of the shoe interior, and the processing unit being further adapted:
in feature a), to assign the at least one parameter to the manufacturer shoe size,
in feature b), to perform a frequency analysis for the occurrence of specific values of the at least one parameter for shoes of different manufacturers having an identical manufacturer shoe size,
in feature c), to carry out a categorization of the shoes by a new allocation of the shoe size, wherein a new shoe size is allocated to the shoes in such a manner that the at least one parameter of the shoes provided with the new shoe size within the new shoe size has a smaller dispersion than in the original manufacturer shoe size.

12. A device for selecting footwear having an improved fit, comprising a device for categorizing articles of clothing according to claim 11 and an input unit and an output unit, the input unit being adapted to receive information about a shoe size requested by a user, and the processing unit being adapted to offer to the user information about footwear the new shoe size of which corresponds to the shoe size requested by the user, via the output unit.

## Revendications

1. Procédé de catégorisation de vêtements en ce qui concerne leur taille de vêtement qui décrit un ajustement et/ou une taille du vêtement, chaque vêtement étant pourvu d'une taille de vêtement de fabricant déterminée du côté du fabricant, et une population étant considérée, laquelle comprend des vêtements de différentes tailles de vêtement de fabricant, et des vêtements de différents fabricants étant présents dans chaque taille de vêtement de fabricant, le procédé comprenant les étapes suivantes :
a) saisie d'au moins un paramètre décrivant l'ajustement et/ou la taille d'un vêtement à l'aide d'une mesure réalisée sur le vêtement concerné,
b) affectation du paramètre saisi à la taille de vêtement de fabricant du vêtement mesuré,
c) réalisation des étapes a) et b) pour une pluralité de vêtements de fabricants différents qui présentent une taille de vêtement de fabricant identique,
d) réalisation des étapes a) à c) pour une pluralité de tailles de vêtement de fabricant différentes,
e) réalisation d'une analyse fréquentielle pour l'apparition de valeurs spécifiques dudit au moins un paramètre pour des vêtements de fabricants différents qui présentent une taille de vêtement de fabricant identique, l'analyse fréquentielle étant réalisée pour une pluralité de tailles de vêtement de fabricant,
f) catégorisation des vêtements par une nouvelle attribution de la taille de vêtement, la nouvelle taille de vêtement étant attribuée aux vêtements de telle sorte que ledit au moins paramètre de vêtements pourvus de la nouvelle taille de vêtement dans cette nouvelle taille présente une dispersion plus faible que ledit au moins un paramètre saisi par rapport à la taille de vêtement de fabricant.

2. Procédé de catégorisation de vêtements selon la revendication 1, dans lequel un nombre caractéristique statistique caractérisant la distribution des fréquences pour ledit au moins paramètre de la distribution des fréquences respective est déterminé pour chacune des tailles de vêtement de fabricant considérées et est attribué à celle-ci, et dans lequel à l'étape f), un écart dudit au moins paramètre d'un vêtement à catégoriser du nombre caractéristique statistique correspondant de ce paramètre pour des vêtements de fabricants différents et dans différentes tailles de vêtement de fabricant est déterminé, et dans lequel la nouvelle taille de vêtement est attribuée au vêtement pour laquelle l'écart du nombre caractéristique statistique est minimal.

3. Procédé de catégorisation de vêtements selon la revendication 2, dans lequel le nombre caractéristique statistique caractérisant la distribution des fréquences est une valeur percentile de la distribution des fréquences et/ou une valeur moyenne de la distribution des fréquences.

4. Procédé de catégorisation de vêtements selon l'une des revendications précédentes, dans lequel l'étape a) est réalisée pour des vêtements identiques ou semblables de fabricants différents, au moins un vêtement étant respectivement mesuré de manière représentative pour une taille de vêtement de fabricant d'un fabricant considéré, et dans lequel à l'étape f), une catégorisation est effectuée pour l'ensemble des vêtements de la taille de vêtement de fabricant considérée du fabricant correspondant.

5. Procédé de catégorisation de vêtements selon l'une des revendications précédentes, dans lequel les vêtements sont des chaussures et la taille de vêtement de fabricant est une pointure de fabricant attribuée du côté du fabricant, dans lequel pour la réduction d'une influence négative sur l'ajustement due à des différences de forme intérieure présentes malgré une pointure de fabricant identique :
à l'étape a) une forme intérieure d'une chaussure est saisie et au moins un paramètre décrivant la dimension de l'espace intérieur de chaussure est déterminé,
à l'étape b) ledit au moins un paramètre est affecté à la pointure de fabricant,
les étapes a) et b) sont réalisées pour des modèles de chaussure identiques ou semblables de la production de fabricants différents et pour différentes pointures de fabricant,
à l'étape e) une analyse fréquentielle pour l'apparition de valeurs spécifiques dudit au moins un paramètre est réalisée pour des chaussures de fabricants différents mais avec une pointure de fabricant identique,
à l'étape f) une catégorisation des chaussures est effectuée par une nouvelle attribution de la pointure, la nouvelle pointure étant attribuée aux chaussures de telle sorte que ledit au moins un paramètre des chaussures pourvues de la nouvelle pointure dans la nouvelle pointure présente une dispersion plus faible que dans le cas des pointures de fabricant d'origine.

6. Procédé de catégorisation de vêtements selon la revendication 5, dans lequel
à l'étape a), au moins une chaussure par modèle de chaussure et par pointure de fabricant est mesurée de façon représentative pour le modèle de chaussure et la pointure de fabricant au moyen d'un scanner d'espace intérieur de chaussure et au moins une grandeur anatomiquement importante est saisie en tant que paramètre décrivant la dimension d'espace intérieur de chaussure,
à l'étape e) une fonction de fréquence à une dimension est formée pour la grandeur anatomiquement importante choisie,
une fonction d'appartenance est fixée, laquelle définit une plage de valeurs de la grandeur anatomiquement importante concernée, et cette fonction d'appartenance est attribuée à une nouvelle pointure,
à l'étape f), une catégorisation des chaussures est effectuée par une nouvelle attribution des pointures de telle sorte que la fonction de fréquence à une dimension du paramètre décrivant la grandeur anatomiquement importante présente dans la nouvelle pointure une dispersion plus faible que dans la pointure de fabricant d'origine.

7. Procédé de catégorisation de vêtements selon la revendication 5 ou 6, dans lequel
à l'étape a) au moins une chaussure par modèle de chaussure et par pointure de fabricant est mesurée au moyen d'un scanner d'espace intérieur de chaussure et n >= 2 dimensions d'espace intérieur sont extraites de ces mesures,
à l'étape d) une fonction de fréquence à n dimensions par modèle de chaussure et par fabricant est formée pour les n grandeurs anatomiques choisies,
une fonction d'appartenance à n dimensions est fixée laquelle définit une plage de valeurs des n grandeurs anatomiques,
à l'étape f) les pointures pour tous les fabricants considérés sont de nouveau attribuées de sorte que les n dimensions d'espace intérieur dans la nouvelle pointure présentent une dispersion plus faible que dans les pointures de fabricant d'origine.

8. Procédé de catégorisation de vêtements selon l'une des revendications 1 à 4, dans lequel les vêtements sont des vêtements de protection ou des pièces médicales adaptées au corps telles que des supports, des attelles ou des protecteurs.

9. Procédé de sélection d'articles chaussants à ajustement amélioré, dans lequel des pointures sont réattribuées selon un procédé de catégorisation selon l'une des revendications 5 à 7 et des chaussures sont offertes à un utilisateur sur demande d'une pointure spécifique, dont la nouvelle pointure correspond à la demande de l'utilisateur.

10. Dispositif de catégorisation de vêtements en ce qui concerne leur taille de vêtement qui décrit un ajustement et/ou une taille du vêtement, chaque vêtement étant pourvu d'une taille de vêtement de fabricant déterminée du côté du fabricant, et une population étant considérée, laquelle comprend des vêtements de différentes tailles de vêtement de fabricant, et des vêtements de fabricants différents étant présents dans chaque taille de vêtement de fabricant, le dispositif comportant un scanner pour la saisie d'au moins un paramètre décrivant l'ajustement et/ou la taille d'un vêtement et une unité de traitement, l'unité de traitement étant adaptée pour :
a) affecter ledit au moins paramètre saisi à la taille de vêtement de fabricant,
b) réaliser une analyse fréquentielle pour l'apparition de valeurs spécifiques dudit au moins un paramètre pour des vêtements de fabricants différents qui présentent une taille de vêtement de fabricant identique, et réaliser l'analyse fréquentielle pour une pluralité de vêtements de fabricants différents mais présentant une taille de vêtement de fabricant identique et pour différentes tailles de vêtement de fabricant,
c) catégoriser les vêtements par une nouvelle attribution de la taille de vêtement et attribuer la nouvelle taille de vêtement aux vêtements de telle sorte que ledit au moins paramètre des vêtements pourvus de la nouvelle taille de vêtement dans cette nouvelle taille présente une dispersion plus faible que dans la taille de vêtement de fabricant d'origine.

11. Dispositif de catégorisation de vêtements selon la revendication 10, dans lequel les vêtements sont des chaussures et la taille de vêtement de fabricant est une pointure de fabricant attribuée du côté du fabricant, le scanner étant un scanner pour la saisie d'une forme intérieure de chaussure et étant en outre adapté pour déterminer au moins un paramètre décrivant la dimension d'espace intérieur de chaussure, et l'unité de traitement étant en outre adapter pour :
allouer à la caractéristique a) ledit au moins un paramètre à la pointure de fabricant,
réaliser à la caractéristique b) une analyse fréquentielle pour l'apparition de valeurs spécifiques dudit au moins un paramètre pour des chaussures de fabricants différents mais avec une pointure de fabricant identique,
effectuer à la caractéristique c) une catégorisation des chaussures par une nouvelle attribution de la pointure, une nouvelle pointure étant attribuée aux chaussures de telle sorte que ledit au moins un paramètre des chaussures pourvues de la nouvelle pointure présente dans la nouvelle pointure une dispersion plus faible que dans le cas des pointures de fabricant d'origine.

12. Dispositif de sélection d'articles chaussants à ajustement amélioré, comprenant un dispositif de catégorisation de vêtements selon la revendication 11 et une unité d'entrée et une unité de sortie, l'unité d'entrée étant adaptée pour recevoir des informations quant à une pointure souhaitée par un utilisateur, et l'unité de traitement étant adaptée pour offrir à l'utilisateur des information quant à des articles chaussants dont la nouvelle pointure correspond à la pointure désirée par l'utilisateur par l'intermédiaire de l'unité de sortie.
